# EUROPÄISCHE PATENTSCHRIFT

(11) **EP 3 783 137 B1**
(45) Veröffentlichungstag und Bekanntmachung des Hinweises auf die Patenterteilung: **20.07.2022**
(21) Anmeldenummer: 20190085.9
(22) Anmeldetag: 07.08.2020
(51) Int. Cl.: D01H 13/32, B65H 63/00

(54) **VERFAHREN ZUM BESTIMMEN EINER ELEKTRISCHEN LEISTUNG ODER EINES ELEKTRISCHEN ENERGIEVERBRAUCHS EINER SPINN- ODER SPULMASCHINE UND SPINN- ODER SPULMASCHINE**
METHOD FOR DETERMINING AN ELECTRICAL POWER OR ELECTRICAL ENERGY CONSUMPTION OF A SPINNING OR WINDING MACHINE AND SPINNING OR WINDING MACHINE
PROCÉDÉ DE DÉTERMINATION D'UNE PUISSANCE ÉLECTRIQUE OU D'UNE CONSOMMATION D'ÉNERGIE ÉLECTRIQUE D'UNE MACHINE DE FILATURE OU DE BOBINAGE ET MACHINE DE FILATURE OU DE BOBINAGE

(30) Priorität: 22.08.2019 DE 102019122609
(43) Veröffentlichungstag der Anmeldung: 24.02.2021
(73) Patentinhaber: Maschinenfabrik Rieter AG, 8406 Winterthur (CH)
(72) Erfinder: Bahlmann, Bernd, 86529 Schrobenhausen (DE); Zipperer, Martin, 92339 Beilngries (DE); Hüttinger, Franz, 85290 Geisenfeld (DE); Reuthlinger, Julian, 85049 Ingolstadt (DE)
(74) Vertreter: Canzler & Bergmeier Patentanwälte Partnerschaft mbB

(56) Entgegenhaltungen:
- DE-A1-102014 016 785
- DE-A1-102017 112 080
- DE-A1-102017 120 714

## Beschreibung

Die vorliegende Erfindung betrifft ein Verfahren zum Bestimmen einer elektrischen Leistung oder eines elektrischen Energieverbrauchs an einer Spinn-oder Spulmaschine, insbesondere einer Offenend- oder Luftspinnmaschine, mit einer Vielzahl nebeneinander angeordneter Arbeitsstellen, welche jeweils wenigstens ein elektrisches Arbeitsorgan aufweisen, wobei bei dem Verfahren eine elektrische Gesamtleistung oder ein elektrischer Gesamtenergieverbrauch der Spinn- oder Spulmaschine ermittelt wird. Weiterhin betrifft die Erfindung eine Spinn- oder Spulmaschine, insbesondere Offenend- oder Luftspinnmaschine, zur Durchführung des Verfahrens, wobei die Spinn- oder Spulmaschine eine Vielzahl nebeneinander angeordneter Arbeitsstellen aufweist, welche jeweils wenigstens ein elektrisches Arbeitsorgan aufweisen.

Gattungsgemäße Spinn- oder Spulmaschinen sind in verschiedenen Ausführungen aus dem Stand der Technik bekannt. So offenbart beispielsweise die DE 39 11 850 A1 eine Ringspinnmaschine, bei der der Betriebszustand der Produktionsstellen jeweils über die Strom- oder Leistungsaufnahme eines bestimmten Antriebs der betreffenden Produktionsstelle bestimmt wird. Der Antrieb kann beispielsweise der Spindelmotor sein. Bei einem Fadenbruch wird dabei die Stromaufnahme des Spindelmotors sinken, während sie bei einer zu hohen Fadenspannung steigt.

Die DE 10 2007 053 711 A1 offenbart eine kreuzspulenherstellende Spinn-oder Spulmaschine, bei der der Motorstrom für den elektromotorischen Antrieb der Auflösewalze überwacht wird, um dabei auf das Vorhandensein eines Faserbandes zu schließen.

Die DE 10 2015 014 383 A1 betrifft weiterhin eine Doppeldrahtzwirn- oder Kabliermaschine, bei der die Energieaufnahme des Spindelantriebs ermittelt wird. Auf Basis dieser Messung wird die Position der Ballonfadenführeröse so einjustiert, dass ein positionsabhängiger, minimaler Energieverbrauch des Spindelantriebs erreicht wird.

Die DE 10 2013 111 245 A1 offenbart weiterhin eine Rotorspinnmaschine mit einem Rotoreinzelantrieb, bei der der Speisestrom oder die Leistungsaufnahme des Antriebs überwacht werden. Durch Veränderungen des Speisestroms kann ein Fadenbruch oder eine Fehler beim Anspinnvorgang an der jeweiligen Arbeitsstelle detektiert werden.

Die so ermittelten elektrischen Werte erlauben ausschließlich Rückschlüsse auf Vorgänge an einzelnen Arbeitsstellen bzw. an einzelnen Antrieben. Bei Textilmaschinen und insbesondere Spinnmaschinen ist jedoch auch der gesamte Energieverbrauch von großer Bedeutung, da dieser die Produktionskosten maßgeblich beeinflusst.

In der DE 10 2014 016 785 A1 wird daher vorgeschlagen, die Gesamtleistungsaufnahme der Spinn- oder Spulmaschine zu berechnen, indem die Einzelwerte der Leistungsaufnahmen der einzelnen Antriebe oder deren Frequenzumrichter addiert werden. Dabei können auch Korrekturen vorgenommen werden, die den Wirkungsgrad der Frequenzumrichter oder bestimmte Betriebszustände der Antriebe umfassen.

Aufgabe der vorliegenden Erfindung ist es, ein Verfahren zum Bestimmen einer elektrischen Leistung oder eines elektrischen Energieverbrauchs an einer Spinn- oder Spulmaschine sowie eine Spinn- oder Spulmaschine vorzuschlagen, die eine verbesserte Erfassung von Energieverbrauchs- oder Leistungsdaten ermöglichen.

Die Aufgabe wird gelöst durch ein Verfahren zum Bestimmen einer elektrischen Leistung oder eines elektrischen Energieverbrauchs einer Spinn- oder Spulmaschine sowie eine Spinn- oder Spulmaschine mit den Merkmalen der unabhängigen Patentansprüche.

Vorgeschlagen wird ein Verfahren zum Bestimmen einer elektrischen Leistung und/oder eines elektrisches Energieverbrauchs an einer Spinn- oder Spulmaschine, insbesondere einer Offenend- oder Luftspinnmaschine, mit einer Vielzahl nebeneinander angeordneter Arbeitsstellen, welche jeweils wenigstens ein elektrisches Arbeitsorgan aufweisen. Bei dem Verfahren wird eine elektrische Gesamtleistung der Spinn- oder Spulmaschine ermittelt.

Bei den Arbeitsstellen handelt es sich üblicherweise um gleichartige Arbeitsstellen. Die Arbeitsorgane der Arbeitsstellen können dabei, wie im Stand der Technik bekannt, sowohl jeweils mittels eines arbeitsstelleneigenen Einzelantriebs als auch gruppenweise mittels eines Zentralantriebs angetrieben sein. Weiterhin können die Arbeitsstellen über Verbraucher verfügen, welche zwar elektrische Energie verbrauchen, jedoch nicht angetrieben werden.

Zum Bestimmen der elektrischen Leistung und/oder des wird vorgeschlagen, dass die Arbeitsstellen in wenigstens zwei unabhängig voneinander betreibbare Produktionsgruppen unterteilt werden und die elektrische Gesamtleistung und/oder ein elektrischer Gesamtenergieverbrauch der Spinn- oder Spulmaschine mittels einer ersten, zentralen Messeinrichtung gemessen wird. Weiterhin wird ein Verteilerschlüssel vorgegeben und es wird für jede der Produktionsgruppen eine Produktionsgruppenleistung und/oder ein Produktionsgruppenenergieverbrauch berechnet, indem die elektrische Gesamtleistung und/oder der elektrische Gesamtenergieverbrauch der Spinn- oder Spulmaschine mittels des Verteilerschlüssels auf die einzelnen Produktionsgruppen aufgeteilt wird. Die Produktionsgruppenleistung und/oder der Produktionsgruppenenergieverbrauch wird an der Spinn- oder Spulmaschine angezeigt und/oder an einen der Spinn- oder Spulmaschine übergeordneten Rechner übermittelt.

Unter einer Produktionsgruppe wird dabei eine Gruppe von Arbeitsstellen einer Spinn- oder Spulmaschine verstanden, welche jeweils das gleiche Produkt in Bezug auf die Garnparameter herstellen bzw. spulen und dabei unabhängig von anderen Produktionsgruppen arbeiten.

Mittels des Verfahrens ist es nicht nur möglich, die aktuelle Gesamtleistung bzw. den Gesamtenergieverbrauch der Spinn- oder Spulmaschine zu bestimmen, sondern es ist zusätzlich auch möglich, für jede Produktionsgruppe einzeln die aktuell aufgenommene Produktionsgruppenleistung bzw. den Produktionsgruppenenergieverbrauch zu bestimmen. Dies ist wesentlich, da unterschiedliche Garne mit unterschiedlichen Garnparametern auch unterschiedliche Einstellungen an den Arbeitsstellen erfordern. Dementsprechend kann es zu erheblichen Unterschieden bezüglich der aufgenommenen Leistung bzw. des Energieverbrauchs der einzelnen Produktionsgruppen kommen. Die elektrische Leistung gibt dabei über den aktuellen Betriebszustand der jeweiligen Produktionsgruppe Aufschluss. Durch die Ermittlung der Produktionsgruppenleistung und/oder des Produktionsgruppenenergieverbrauchs können die Einstellungen für die Herstellung des jeweiligen Produktes produktionsgruppenspezifisch optimiert werden. Ebenso können Fehler erkannt werden, welche beispielsweise aufgrund der Garncharakteristik oder der Einstellparameter nur in einer bestimmten Produktionsgruppe auftreten. Ebenso können hierdurch die Kosten für die Produktion des in der jeweiligen Produktionsgruppe produzierten Garns genau ermittelt werden.

Die Ermittlung der Gesamtleistung und/oder des Gesamtenergieverbrauchs der Spinn- oder Spulmaschine sowie die Berechnung der Produktionsgruppenleistung und/oder des Produktionsgruppenenergieverbrauchs kann mittels des vorgeschlagenen Verfahrens besonders genau erfolgen, da nicht nur wie im Stand der Technik die Leistungs- und/oder Energiedaten der Arbeitsorgane der Arbeitsstellen ermittelt werden, sondern vielmehr auch die Leistung und/oder der Energieverbrauch übergeordneter Antriebe und weiterer elektrischer Verbraucher mit herangezogen wird. Dies erfolgt gemäß dem Verfahren dadurch, dass die elektrische Gesamtleistung der Spinn- oder Spulmaschine gemessen wird. Ebenso wird die Produktionsgruppenleistung nicht lediglich durch Addition der Leistungen der Antriebe dieser Produktionsgruppe ermittelt, sondern genau berechnet, indem die Gesamtleistung der Spinn oder Spulmaschine mittels des Verteilerschlüssels anteilig den einzelnen Produktionsgruppen zugeordnet wird. Selbiges gilt in analoger Weise für die Ermittlung des Gesamtenergieverbrauchs sowie die Berechnung des Produktionsgruppenenergieverbrauchs. Durch die Anzeige und/oder Übermittlung der Produktionsgruppenleistung und/oder der Produktionsgruppenenergieverbräuche an einen übergeordneten Rechner wird das Bedienpersonal schnell über den Betriebszustand und/oder die Effizienz der Spinn- oder Spulmaschine und ihrer Produktionsgruppen informiert und kann Wartungsarbeiten an der Spinn-oder Spulmaschine vornehmen oder Parameter anpassen. Durch die Übermittlung an einen übergeordneten Rechner können die Daten zudem analysiert oder zentral gespeichert werden und mit Daten anderer Spinn- oder Spulmaschinen verglichen werden.

Es wird weiterhin eine entsprechende Spinn- oder Spulmaschine, insbesondere eine Offenend- oder Luftspinnmaschine vorgeschlagen. Die Spinn- oder Spulmaschine weist eine erste, zentrale Messeinrichtung zur Messung einer Gesamtleistung oder eines Gesamtenergieverbrauchs der Spinn- oder Spulmaschine sowie eine Steuereinheit zur Durchführung des Verfahrens auf. Zur Anzeige der Produktionsgruppenleistung und/oder des Produktionsgruppenenergieverbrauchs weist die Spinn- oder Spulmaschine vorzugsweise mindestens eine mit der Steuereinheit verbundene Anzeigeeinheit auf. Diese kann sich dabei sowohl an der jeweiligen Produktionsgruppe befinden oder auch zentral an der Spinn- oder Spulmaschine angeordnet sein.

Vorteilhaft ist es bei dem Verfahren, wenn ein spezifischer Energieverbrauch in kW/g Garn oder in kW/m Garn für jede der Produktionsgruppen und/oder für die gesamte Spinn- oder Spulmaschine bestimmt wird. Der spezifische Energieverbrauch gibt Auskunft über den Energieverbrauch bzw. die Kosten für die Produktion eines bestimmten Garns und lässt Rückschlüsse auf die Effizienz der Produktionsgruppe oder auch der gesamten Spinn- oder Spulmaschine zu. Der spezifische Energieverbrauch kann mit Hilfe der Liefergeschwindigkeit und ggf. weiterer Parameter aus der Produktionsgruppenleistung oder dem Produktionsgruppenenergieverbrauch ermittelt werden. Vorzugsweise wird der spezifische Energieverbrauch ebenfalls an der Spinn-oder Spulmaschine angezeigt und/oder an einen der Spinn- oder Spulmaschine übergeordneten Rechner übermittelt.

Nach einer ersten vorteilhaften Ausführung des Verfahrens wird die gemessene elektrische Gesamtleistung und/oder der gemessene elektrische Gesamtenergieverbrauch entsprechend der Anzahl aktiv arbeitender Arbeitsstellen auf die einzelnen Produktionsgruppen aufgeteilt. Zur Ermittlung der Produktionsgruppenleistung wird die gemessene Gesamtleistung der Spinn-oder Spulmaschine durch die gesamte Anzahl aktiv arbeitender Arbeitsstellen geteilt und hierdurch eine Leistung je Arbeitsstelle ermittelt. Diese wird sodann mit der Anzahl an Arbeitsstellen der jeweiligen Produktionsgruppe multipliziert und damit die Produktionsgruppenleistung als Anteil der jeweiligen Produktionsgruppe an der Gesamtleistung ermittelt. In analoger Weise gilt dies natürlich auch für die Ermittlung des Produktionsgruppenenergieverbrauchs.

Aktiv arbeitende Arbeitsstellen sind dabei Arbeitsstellen, die produzieren oder sich gerade in einem regulären Wartungszyklus wie beispielsweise einem Ansetzzyklus oder einem Spulenwechselzyklus befinden. Arbeitsstellen, die defekt oder ausgeschaltet sind oder auf Fehler gelaufen sind, sind entsprechend nicht aktiv arbeitende Arbeitsstellen.

Nach einer alternativen Ausführung des Verfahrens wird der gemessene elektrische Gesamtenergieverbrauch entsprechend der Anzahl der Ansetzvorgänge innerhalb eines bestimmten Zeitraums auf die einzelnen Produktionsgruppen aufgeteilt. Zur Ermittlung des Produktionsgruppenenergieverbrauchs wird der gemessene elektrische Gesamtenergieverbrauch der Spinn- oder Spulmaschine durch die gesamte Anzahl an Ansetzvorgängen innerhalb des bestimmten Zeitraums geteilt und hierdurch ein Energieverbrauch je Ansetzvorgang ermittelt. Dieser wird sodann mit der Anzahl an Ansetzvorgängen der jeweiligen Produktionsgruppe multipliziert und damit der Produktionsgruppenenergieverbrauch als Anteil der jeweiligen Produktionsgruppe an dem Gesamtenergieverbrauch ermittelt. In analoger Weise ist dies auch für die Ermittlung der Produktionsgruppenleistung denkbar. Da Ansetzvorgänge besonders energieintensiv sind, ist die Anzahl der Ansetzvorgänge ein besonders gut geeigneter Parameter zur Bestimmung des Produktionsgruppenenergieverbrauchs. Vorteilhaft dabei ist es auch, dass sich bestimmte Garneigenschaften oftmals auch in der Anzahl der Ansetzvorgänge abbilden. Mit der Aufteilung entsprechend der Anzahl der Ansetzvorgänge kann daher eine etwas genauere Aufteilung des Gesamtenergieverbrauchs bzw. der Gesamtleistung auf die einzelnen Produktionsgruppen erfolgen. Nach einer anderen vorteilhaften Ausführung des Verfahrens wird für jede der Produktionsgruppen eine elektrische Leistung und/oder ein elektrischer Energieverbrauch der Arbeitsorgane der Arbeitsstellen der jeweiligen Produktionsgruppe ermittelt und die so ermittelten elektrischen Leistungen werden in ein Verhältnis zueinander gesetzt. Schließlich wird für jede der Produktionsgruppen eine Produktionsgruppenleistung und/oder ein Produktionsgruppenenergiebedarf berechnet, indem die gemessene elektrische Gesamtleistung und/oder der gemessene elektrische Gesamtenergieverbrauch der Spinn-oder Spulmaschine entsprechend dem Verhältnis der ermittelten Leistungen und/oder Energieverbräuche der Arbeitsorgane der Produktionsgruppen auf die einzelnen Produktionsgruppen aufgeteilt wird. Hierdurch kann eine besonders genaue Ermittlung der Produktionsgruppenleistung und/oder des Produktionsgruppenenergiebedarfs erfolgen.

Vorteilhaft für die Messung der elektrischen Gesamtleistung der Spinn- oder Spulmaschine ist es, wenn die erste zentrale Messeinrichtung als Leistungsmessmodul ausgebildet ist. Solche Leistungsmessmodule können dabei fest in der Spinn- oder Spulmaschine eingebaut sein und die Leistungsaufnahme der gesamten Spinn- oder Spulmaschine direkt messen.

Um die elektrische Gesamtleistung und/oder den elektrischen Gesamtenergieverbrauch zu messen, ist es weiterhin vorteilhaft, wenn die erste, zentrale Messeinrichtung im Bereich eines Netzanschlusses der Spinn- oder Spulmaschine angeordnet ist. Hierdurch kann sichergestellt werden, dass auch tatsächlich die Gesamtleistung bzw. der Gesamtenergieverbrauch der Spinn-oder Spulmaschine, also aller der Spinn- oder Spulmaschine zugehöriger Verbraucher erfasst wird.

Nach einer Weiterbildung des Verfahrens umfasst eine Produktionsgruppe die Arbeitsstellen einer Längsseite der Spinn- oder Spulmaschine. Hierdurch können auch an Maschinen mit zentral angetriebenen Arbeitsorganen zwei voneinander unabhängige Produktionsgruppen realisiert werden.

Dabei ist es besonders vorteilhaft, wenn die elektrischen Arbeitsorgane der zu einer Produktionsgruppe gehörenden Arbeitsstellen durch einen gemeinsamen, zentralen Antrieb angetrieben werden.

Umfasst eine Produktionsgruppe jeweils eine Längsseite der Spinn- oder Spulmaschine, so wird für jede Längsseite jeweils ein eigener zentraler Antrieb vorgesehen, welcher dann alle Arbeitsstellen dieser Längsseite bzw. dieser Produktionsgruppe antreibt. Sind mehrere, verschiedenartige Arbeitsorgane an jeder der Arbeitsstellen vorhanden, so werden vorzugsweise jeweils gleichartige Arbeitsorgane der Arbeitsstellen einer Längsseite jeweils mittels eines eigenen Zentralantriebs angetrieben. Natürlich ist es aber auch denkbar, dass an einer Längsseite zwei oder sogar mehr Produktionsgruppen vorgesehen sind und für jede Produktionsgruppe ein eigener zentraler Antrieb vorgesehen ist bzw. bei mehreren verschiedenartigen Arbeitsorganen auch mehrere zentrale Antriebe je Produktionsgruppe vorgesehen sind, die beispielsweise in Zwischengestellen angeordnet sind. Weiterhin ist es vorteilhaft, wenn die Leistung und/oder der Energieverbrauch der Arbeitsorgane einer Produktionsgruppe durch eine weitere, der jeweiligen Produktionsgruppe zugeordnete Messeinrichtung gemessen werden. Die Spinn- oder Spulmaschine umfasst hierzu wenigstens eine weitere Messeinrichtung zur Messung einer Leistung und/oder eines Energieverbrauchs der Arbeitsorgane einer Produktionsgruppe. Insbesondere, wenn die elektrischen Arbeitsorgane einer Produktionsgruppe durch einen oder mehrere gemeinsame, zentrale Antriebe angetrieben werden, kann auf diese Weise die Leistung und/oder der Energieverbrauch der Arbeitsorgane der Produktionsgruppe leicht direkt an den Antrieben oder deren Leistungssträngen erfasst werden.

Vorteilhaft ist es daher auch, wenn die wenigstens eine weitere, der jeweiligen Produktionsgruppe zugeordnete Messeinrichtung als Aufsteckwandler ausgebildet ist. Aufsteckwandler können einfach und flexibel um ein Stromkabel gelegt werden und messen die Leistungsaufnahme und/oder den Energieverbrauch des Abschnitts der Spinn- oder Spulmaschine, der von diesem Stromkabel gespeist wird. Sie sind daher insbesondere für Spinn-oder Spulmaschinen, bei denen die Arbeitsorgane der Arbeitsstellen mit Zentralantrieben angetrieben werden, geeignet.

Nach einer anderen Ausführung der Spinn- oder Spulmaschine ist es jedoch auch vorteilhaft, wenn die Arbeitsstellen als zumindest teilweise autarke Arbeitsstellen ausgebildet sind, wobei das wenigstens eine Arbeitsorgan mittels eines Einzelantriebs angetrieben ist. Bei dem Verfahren ist es entsprechend vorteilhaft, wenn das wenigstens eine elektrische Arbeitsorgan jeder Arbeitsstelle durch einen arbeitsstelleneigenen Einzelantrieb angetrieben wird. Es ist hierdurch möglich, die Arbeitsstellen beliebig und völlig unabhängig von ihrer Anordnung innerhalb der Spinn- oder Spulmaschine in unterschiedliche Produktionsgruppen zu unterteilen. Ebenso kann auch die Anzahl der Produktionsgruppen beliebig festgelegt werden.

Bei dem Verfahren ist es vorteilhaft, wenn die Unterteilung der Arbeitsstellen in Produktionsgruppen dynamisch wechselnd erfolgt. Hierdurch kann beispielsweise an einer Arbeitsstelle sofort nach Beendigung einer Partie eine neue Partie begonnen werden bzw. ein neues Produkt hergestellt werden. Die Arbeitsstelle kann einer neuen Produktionsgruppe zugeordnet werden, ohne dass das Beenden der Partie der weiteren, zu der ursprünglichen Produktionsgruppe gehörenden Arbeitsstellen abgewartet werden muss.

Dabei ist es weiterhin vorteilhaft, wenn die Leistung und/oder der Energieverbrauch der Arbeitsorgane einer Produktionsgruppe ermittelt wird, indem die einzelnen Leistungen und/oder Energieverbräuche der Einzelantriebe der zu der jeweiligen Produktionsgruppe gehörenden Arbeitsstellen addiert werden. Die Leistung und/oder der Energieverbrauch des wenigstens einen arbeitsstelleneigenen Einzelantriebs wird hierzu mittels einer weiteren, dem Einzelantrieb zugeordneten Messeinrichtung gemessen. Die Spinn- oder Spulmaschine weist hierzu wenigstens eine weitere Messeinrichtung zur Messung einer Leistung und/oder eines Energieverbrauchs eines arbeitsstelleneigenen Einzelantriebs auf. Vorteilhafterweise ist bei einer solchen Spinn-oder Spulmaschine mit einzeln angetriebenen Arbeitsorganen die wenigstens eine weitere Messeinrichtung eine dem Einzelantrieb zugeordnete Steuereinheit, insbesondere eine Sektionssteuereinheit. Die Arbeitsstellen von Spinn- oder Spulmaschinen sind üblicherweise baulich in mehrere, baugleiche Sektionen untergliedert. Die Sektionssteuereinheit steuert die einzelnen, an sie angeschlossenen Arbeitsorgane direkt an oder leitet zumindest Steuerdaten für die Arbeitsorgane weiter und kann daher auch deren Leistung und/oder Energieverbrauch ermitteln, auch wenn diese unterschiedlichen Produktionsgruppen angehören.

Zusätzlich oder alternativ ist es aber auch möglich, dass die wenigstens eine weitere Messeinrichtung als eine in den Einzelantrieb integrierte Erfassungseinrichtung ausgebildet ist, beispielsweise als eine Steuerungselektronik des Einzelantriebs. Die integrierte Erfassungseinrichtung kann die Leistung und/oder den Energieverbrauch direkt oder gegebenenfalls auch über die zuvor beschriebene Sektionssteuereinheit an eine Auswerteeinheit weitergeben, welche dann anhand der so gewonnenen Daten die Produktionsgruppenleistung bzw. den Produktionsgruppenenergieverbrauch ermittelt.

Nach einer ersten Ausführung des Verfahrens ist es vorteilhaft, wenn die Produktionsgruppenleistungen und/oder die Produktionsgruppenenergieverbräuche lediglich in bestimmten Zeitabständen berechnet werden. Beispielsweise kann die Produktionsgruppenleistung nur in bestimmten, vorzugsweise regelmäßigen Zeitabständen berechnet werden, was noch immer ausreichend Rückschlüsse auf den aktuellen Betriebszustand der jeweiligen Produktionsgruppe bzw. auch der Spinn- oder Spulmaschine zulässt, aber die Rechenleistung und den Datenverkehr minimiert. Alternativ können die die Produktionsgruppenleistungen und/oder die Produktionsgruppenenergieverbräuche aber auch laufend berechnet werden. Die Gesamtleistung und/oder der Gesamtenergieverbrauch der Spinn- oder Spulmaschine können ebenfalls sowohl laufend als auch nur in bestimmten Zeitabständen gemessen werden. Selbiges gilt auch für den spezifischen Energieverbrauch.

Ebenso können der Gesamtenergieverbrauch und die Produktionsgruppenenergieverbräuche in einem vorgebbaren oder vorgegebenen Zeitraum ermittelt werden. Diese Energiedaten lassen Rückschlüsse auf die Effizienz der Produktionsgruppe zu. Der Zeitraum, über den der Energieverbrauch ermittelt wird, ist entweder vom Anwender vorgebbar oder fest vorgegeben und kann ein bestimmtes Zeitintervall sein oder auch die Zeit seit einem bestimmten Ereignis, zum Beispiel einem Maschinenstopp oder einem Partiewechsel.

Vorteilhaft ist es weiterhin, wenn die Gesamtleistung und/oder die Produktionsgruppenleistung und/oder der Gesamtenergieverbrauch und/oder die Produktionsgruppenenergieverbräuche und/oder der spezifische Energieverbrauch je Produktionsgruppe zumindest in bestimmten Zeitabständen, vorzugsweise laufend, abgespeichert werden. Die Spinn- oder Spulmaschine weist hierzu vorteilhafterweise ein Speichermedium auf, welches mit der Steuereinheit verbunden ist. Die Daten zum Energieverbrauch bzw. zur Leistung können hierdurch auch zu einem späteren Zeitpunkt noch analysiert werden und lassen Rückschlüsse auf Fehler im Prozess zu.

Alternativ oder zusätzlich können die die Gesamtleistung und/oder die Produktionsgruppenleistung und/oder der Gesamtenergieverbrauch und/oder die Produktionsgruppenenergieverbräuche und/oder der spezifische Energieverbrauch je Produktionsgruppe zumindest in bestimmten Zeitabständen, vorzugsweise laufend,direkt dem Bediener angezeigt werden. Die Spinn- oder Spulmaschine weist hierzu vorzugsweise mindestens eine mit der Steuereinheit verbundene Anzeigeeinheit auf. Das Bedienpersonal wird hierdurch schnell über den Betriebszustand und/oder die Effizienz der Spinn- oder Spulmaschine und ihrer Produktionsgruppen informiert und kann Wartungsarbeiten an der Spinn- oder Spulmaschine vornehmen oder Parameter anpassen.

Ebenfalls vorteilhaft ist es, wenn die Gesamtleistung und/oder die Produktionsgruppenleistung und/oder der Gesamtenergieverbrauch und/oder die Produktionsgruppenenergieverbräuche und/oder der spezifische Energieverbrauch zumindest in bestimmten Zeitabständen, vorzugsweise laufend, an einen der Spinn- oder Spulmaschine übergeordneten Rechner übermittelt werden. Die Spinn-oder Spulmaschine, insbesondere deren Steuereinheit, weist hierzu vorteilhafterweise eine Vorrichtung zur Datenübermittlung auf. Die Daten können dann wiederum analysiert oder zentral gespeichert werden, so dass sie auch für spätere Analysen und Vergleiche mit anderen Spinn- oder Spulmaschine zur Verfügung stehen und mit Daten anderer Spinn- oder Spulmaschinen verglichen werden.

Für die Anzeige der Gesamtleistung und/oder der Produktionsgruppenleistungen und/oder des Gesamtenergieverbrauchs und/oder des Produktionsgruppenenergieverbrauchs und/oder des spezifischen Energieverbrauchs ist es weiterhin vorteilhaft, wenn diese als aktueller Wert, insbesondere numerisch, angezeigt wird/werden. Alternativ könnte ein aktueller Wert allerdings auch graphisch, beispielsweise durch die Höhe eines Balkens, angezeigt werden. Alternativ oder zusätzlich können ist aber auch eine Anzeige als zeitabhängiger Graph möglich. Ein Zeitfenster des zeitabhängigen Graphen ist dabei vorzugsweise rollend oder beginnt zu einem vorgebbaren und/oder vorgegebenen Zeitpunkt. Die Anzeige als zeitabhängiger Graph lässt auch die Entwicklung der Daten im Zeitfenster verfolgen, wobei Veränderungen auf eine mögliche Fehlfunktion der Produktionsgruppe hindeuten können.

Weitere Vorteile der Erfindung werden anhand der nachfolgenden Ausführungsbeispiele beschrieben. Es zeigen:
- **Figur 1**: eine schematische Draufsicht auf eine Spinn- oder Spulmaschine nach einer ersten Ausführung,
- **Figur 2**: eine schematische Draufsicht auf eine Spinn- oder Spulmaschine nach einer zweiten Ausführung,
- **Figur 3**: eine schematische Draufsicht auf eine Spinn- oder Spulmaschine nach einer dritten Ausführung,
- **Figur 4**: eine schematische Darstellung einer Anzeige von Leistungs- und/oder Energieverbrauchsdaten nach einer ersten Ausführung, sowie
- **Figur 5**: eine schematische Darstellung einer Anzeige von Leistungs- und/oder Energieverbrauchsdaten nach einer zweiten Ausführung.

Bei der nachfolgenden Beschreibung der Figuren werden für Merkmale, die bei den einzelnen Ausführungen bzw. den einzelnen Figuren jeweils identisch oder zumindest vergleichbar sind, gleiche Bezugszeichen verwendet. Einige der Merkmale werden daher nur bei ihrer ersten Erwähnung bzw. nur einmal anhand einer geeigneten Figur erläutert. Sofern diese Merkmale in Verbindung mit den weiteren Figuren nicht nochmals gesondert erläutert werden, entspricht deren Ausgestaltung und/oder Wirkweise der Ausgestaltung und Wirkweise der identischen oder vergleichbaren, beschriebenen Merkmale. Aus Gründen der Übersichtlichkeit ist weiterhin bei mehreren identischen Merkmalen oder Bauteilen in einer Figur nur eines oder sind nur wenige dieser identischen Merkmale beschriftet.

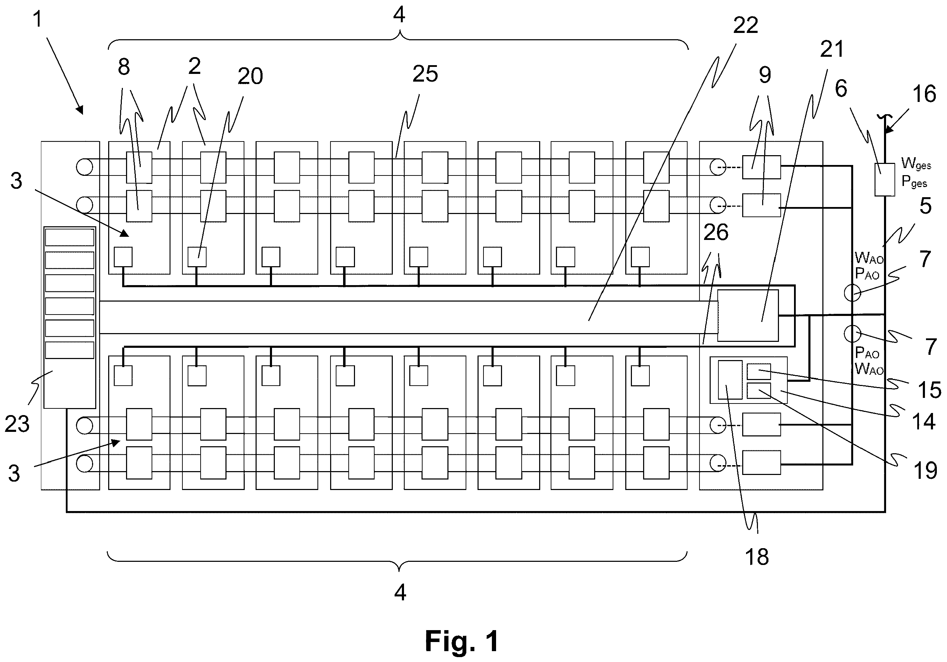

Fig. 1 zeigt eine Draufsicht auf eine Spinn- oder Spulmaschine 1 mit einer Vielzahl an Arbeitsstellen 2. Üblicherweise wird dabei die Anzahl an Arbeitsstellen 2 weitaus größer sein als in Fig. 1 dargestellt. Die Spinn- oder Spulmaschine 1 kann eine beliebige Spinn- oder Spulmaschine 1 mit einer Vielzahl an gleichartigen Arbeitsstellen 2 sein, insbesondere jedoch eine Offenend- oder Luftspinnmaschine. Die Arbeitsstellen 2 sind auf zwei einander gegenüberliegende Längsseiten 3 der Spinn- oder Spulmaschine angeordnet.

Jede der Arbeitsstellen 2 weist zum Produzieren und/oder Aufspulen eines Garns wenigstens ein elektrisches Arbeitsorgan 8 auf. Üblicherweise weist jede Arbeitsstelle 2 mehrere, verschiedenartige Arbeitsorgane 8 auf. Bei einer Rotorspinnmaschine umfassen diese beispielsweise eine Speisevorrichtung, eine Auflösevorrichtung, eine Spinnvorrichtung, eine Abzugsvorrichtung sowie eine Spulvorrichtung. Dabei werden jeweils gleichartige Arbeitsorgane 8 der Arbeitsstellen 2 einer Längsseite 3 wie vorliegend dargestellt jeweils mittels eines separaten, zentralen Antriebs 9 angetrieben. Vorliegend sind an jeder der Arbeitsstellen 2 jeweils zwei verschiedene elektrische Arbeitsorgane 8 dargestellt, sodass entsprechend auf jeder Längsseite jeweils zwei zentrale Antriebe 9 gezeigt sind. Jeder dieser Antriebe 9 beaufschlagt über ein maschinenlanges Antriebsmittel 25 die gleichartigen Arbeitsorgane 8 sämtlicher Arbeitsstellen 2 dieser Längsseite 3. Aufgrund der getrennten zentralen Antriebe 9 je Längsseite 3 kann daher auch jede Längsseite 3 der Spinn- oder Spulmaschine eine eigene Produktionsgruppe 4 bilden.

Die Spinn- oder Spulmaschine 1 weist weiterhin auch noch einen oder mehrere übergeordnete elektrische Verbraucher 20 und/oder Arbeitsorgane 8 auf, die zentrale Funktionen der Spinn- oder Spulmaschine 1 erfüllen und nicht an den einzelnen Arbeitsstellen 2 angeordnet sind. Beispielhaft hier dargestellt sind eine Steuereinheit 14, ein Ventilatorantrieb 21, welcher über einen zentralen Unterdruckkanal 22 die Arbeitsstellen 2 mit Unterdruck versorgt, sowie ein Hülsenlader 23, welcher die einzelnen Arbeitsstellen 2 mit der Lösung versorgt. Weitere solche übergeordneten Arbeitsorgane 8 bzw. elektrischen Verbraucher 20 wären z. B. Spulentransportbänder, Hülsentransportbänder, Schmutztransportbänder und dgl.

Über einen Netzanschluss 16 und ein Stromkabel 5 wird die Spinn- oder Spulmaschine 1 mit elektrischer Energie versorgt. Die übergeordneten elektrischen Verbraucher sind dabei direkt an das Stromkabel 5 angeschlossen. Die Arbeitsstellen 2 werden über mit dem Stromkabel 5 verbundene Leitungsstränge 26 versorgt, wobei im vorliegenden Beispiel an jeder Längsseite 3 der Spinn- oder Spulmaschine 1 ein eigener Leitungsstrang 26 vorgesehen ist, sodass die beiden Längsseiten 3 getrennt voneinander versorgt werden können.

Die Arbeitsstellen 2 können noch weitere elektrische Verbraucher 20 aufweisen, welche jedoch nicht angetrieben sind. Beispiele hierfür wären ein Garnreiniger oder ein Display an den Arbeitsstellen 2. Diese können je nach Bauart entweder an die einzelnen Leitungsstränge 26 oder auch, wie vorliegend dargestellt, an das Stromkabel 5 für die gesamte Spinn- oder Spulmaschine 1 angeschlossen sein.

Dem Stromkabel 5 für die gesamte Spinn- oder Spulmaschine 1 ist eine erste Messeinrichtung 6 zugeordnet, welches die aufgenommene Gesamtleistung Pges der Spinn- oder Spulmaschine 1 misst. Die erste Messeinrichtung 6 ist daher vorzugsweise als Leistungsmessmodul ausgebildet. Durch die Messung der tatsächlich aufgenommenen Gesamtleistung Pges werden nun auch übergeordnete Verbraucher 20 und Arbeitsorgane 8 miterfasst. Demgegenüber wurden im Stand der Technik zur Ermittlung der Gesamtleistung Pges der Spinn- oder Spulmaschine 1 lediglich die Einzelleistungen der Arbeitsorgane 8 der Arbeitsstellen 2 addiert, wodurch die Leistungen der übergeordneten Verbraucher 20 und Arbeitsorgane 8 vernachlässigt wurden.

Weiterhin ist vorliegend jedem der beiden Leitungsstränge 26 der beiden Maschinenseiten 3 jeweils eine weitere Messeinrichtung 7 zugeordnet. Die weitere Messeinrichtung 7 kann beispielsweise als Aufsteckwandler ausgebildet sein und direkt über den jeweiligen Leitungsstrang 26 gelegt werden. Mittels der weiteren Messeinrichtung 7 kann die Leistung PAO sämtlicher an den jeweiligen Leitungsstrang 26 angeschlossener Arbeitsorgane 8 (und gegebenenfalls Verbraucher 20) der Produktionsgruppe 4 gemessen werden. Diese Leistung PAO der Arbeitsorgane 8 der Arbeitsstellen 2 der jeweiligen Produktionsgruppe 4 entspricht jedoch nicht der tatsächlichen Produktionsgruppenleistung PPG, da, wie oben beschrieben, die Leistungen der übergeordneten Arbeitsorgane 8 und Verbraucher 20 fehlt.

Um nun die tatsächliche Produktionsgruppenleistung PPG für jede der beiden Produktionsgruppen 4 zu berechnen, werden daher die gemessenen Leistungen PAO der Arbeitsorgane 2 jeder Produktionsgruppe 4 in ein Verhältnis zueinander gesetzt und die Gesamtleitung Pges der Spinn- oder Spulmaschine 1 wird entsprechend dem Verhältnis der ermittelten Leistungen PAO der Arbeitsorgane 8 der Produktionsgruppen 4 auf die einzelnen Produktionsgruppen 4 aufgeteilt.

Dies soll an einem Zahlenbeispiel verdeutlicht werden: über die erste Messeinrichtung 6 wird beispielsweise eine Gesamtleistung Pges der Spinn- oder Spulmaschine von 100 kW gemessen. Weiterhin wird durch die beiden weiteren Messeinrichtungen 7 für den ersten Leitungsstrang 26 und somit die Arbeitsorgane 8 der ersten Produktionsgruppe 4 eine Leistung PAO von 70 kW gemessen und für den zweiten Leitungsstrang 26 der zweiten Produktionsgruppe 4 eine Leistung PAO von 20 kW gemessen. Das Verhältnis der elektrischen Leistungen PAO der Arbeitsorgane 8 der beiden Produktionsgruppe 4 beträgt somit 7:2. Die gemessene Gesamtleitung Pges wird nun genau im Verhältnis 7:2 auf die beiden Produktionsgruppen 4 aufgeteilt, d.h. 7/9 der gemessenen Gesamtleistung Pges von 100 kW werden der ersten Produktionsgruppe 4 zugeschlagen und 2/9 der zweiten Produktionsgruppe 4. Die so berechnete Produktionsgruppenleistung PPG für die erste Produktionsgruppe 4 beträgt somit 7/9x100 kW = 77,7 kW und für die zweite Produktionsgruppe 4 entsprechend 2/9x100 kW = 22,2 kW. Durch diese Berechnung der Produktionsgruppenleistung 4 kann somit die aufgenommene Leistung der jeweiligen Produktionsgruppe 4 wesentlich genauer bestimmt werden als durch eine alleinige Messung der Leistung der Arbeitsorgane 8 der jeweiligen Produktionsgruppe 4.

In analoger Weise kann natürlich auch ein Produktionsgruppenenergieverbrauch WPG berechnet werden, indem ein Gesamtenergieverbrauch Wges der Spinn- oder Spulmaschine 1 gemessen wird und entsprechend dem Verhältnis der gemessenen oder ermittelten Energieverbräuche WAO der Arbeitsorgane 8 der Produktionsgruppen 4 aufgeteilt wird.

Die Werte, die die erste Messeinrichtung 6 und die weiteren Messeinrichtungen 7 erfassen, werden einer Auswerteeinheit 15 zugeführt, die vorliegend innerhalb der Steuereinheit 14 der Spinn- oder Spulmaschine 1 vorgesehen ist. Die Auswerteeinheit 15 könnte natürlich aber auch unabhängig von der Steuereinheit 14 in der Spinn- oder Spulmaschine 1 vorgesehen sein oder auch mittels einer Vorrichtung zur Datenübertragung einem der Spinn- oder Spulmaschine 1 übergeordneten Rechner zugeführt werden. Mittels der Auswerteeinheit 15 werden die Produktionsgruppenleistungen PPG und/oder die Produktionsgruppenenergieverbräuche WPG berechnet.

Vorliegend ist ebenfalls in der Steuereinheit 14 der Spinn- oder Spulmaschine 1 ein Speichermedium 19 vorgesehen, in welchem sowohl die mittels der Messeinrichtungen 6,7 gemessenen Leistungs- und/oder Energiedaten als auch die daraus berechneten Produktionsgruppenleistungen PPG bzw. Produktionsgruppenenergieverbräuche WPG gespeichert werden können. Das Speichermedium 19 ist zumindest zum kurzfristigen, vorzugsweise auch zum langfristigen Speichern von Daten geeignet. Eine kurzfristige Speicherung ist beispielsweise für die Anzeige der Daten erforderlich, während eine langfristige Speicherung für eine detaillierte Analyse oder rückblickende Berechnungen vorteilhaft ist, beispielsweise um den Betrieb der Spinn- oder Spulmaschine 1 zu optimieren oder um zusätzliche Informationen für die Suche nach einem an der Spinn- oder Spulmaschine 1 aufgetretenen Fehler zu erhalten.

Die Steuereinheit 14 weist weiterhin gemäß vorliegendem Beispiel eine Anzeigeeinheit 18 auf, mittels welcher zumindest die berechneten Produktionsgruppenleistungen PPG bzw. Produktionsgruppenenergieverbräuche WPG angezeigt werden können. Natürlich können auch die weiteren Leistungs- und/oder Energiedaten gegebenenfalls im Wechsel und/oder auf Abruf ebenfalls angezeigt werden.

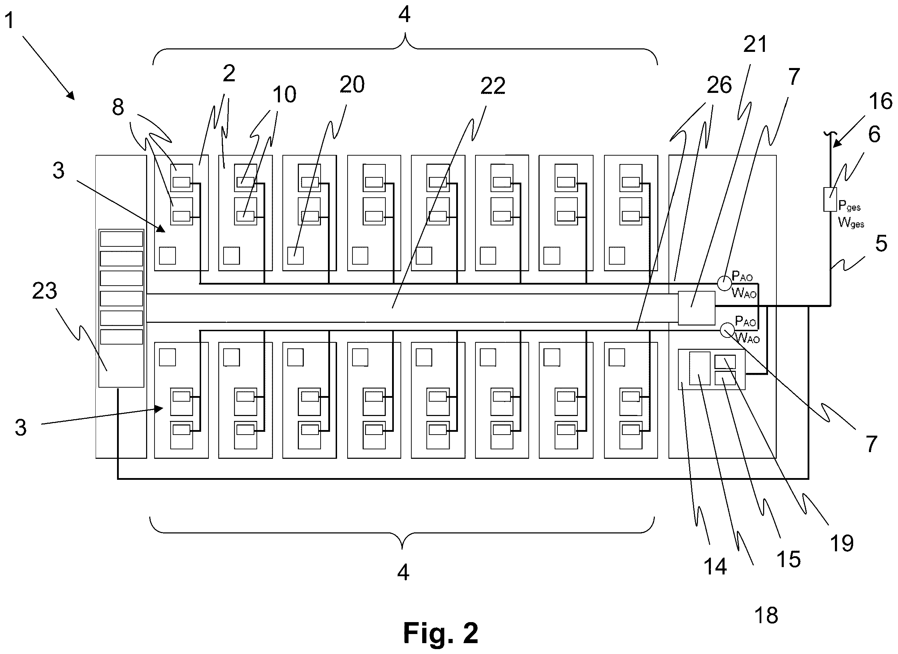

Fig. 2 zeigt eine andere Ausführung einer Spinn- oder Spulmaschine 1, bei der die Arbeitsorgane 8 der Arbeitsstellen 2 nicht mittels zentraler Antriebe 9 angetrieben sind, sondern jeweils mittels eines arbeitsstelleneigenen Einzelantriebs 10. Ebenso wie zuvor beschrieben umfasst jedoch auch bei diesem Ausführungsbeispiel jede Produktionsgruppe 4 die Arbeitsstellen 2 jeweils einer Längsseite 3 der Spinn- oder Spulmaschine 1. Dabei sind wiederum sämtliche Arbeitsorgane 8 der Arbeitsstellen 2 einer Produktionsgruppe 4 an einen Leitungsstrang 26 angeschlossen und werden über diesen gemeinsam versorgt. Es ist auch hier möglich, die elektrische Leistung PAO der Arbeitsorgane 8 einer Produktionsgruppe 4 mittels an den Leitungssträngen 26 angeordneter weiterer Messeinrichtungen 7 zu messen. Die Berechnung der Produktionsgruppenleistungen PPG und/oder der Produktionsgruppenenergieverbräuche WPG erfolgt daher wie zu Fig. 1 beschrieben.

Es versteht sich, dass auch Ausführungen möglich sind, bei denen ein Teil der Arbeitsorgane 8 mittels zentraler Antriebe 9 und ein anderer Teil der Arbeitsorgane 8 mittels Einzelantrieben 10 angetrieben wird. Ebenso könnte eine Produktionsgruppe 4 auch nur einen Teil einer Längsseite 3 umfassen. Wenn die Arbeitsorgane 8 einer Produktionsgruppe 4 jeweils über einen eigenen, dieser Produktionsgruppe 4 zugeordneten Leitungsstrang 26 versorgt werden, kann die Messung und Berechnung der genannten Energie- bzw. Leistungsdaten dennoch wie beschrieben erfolgen.

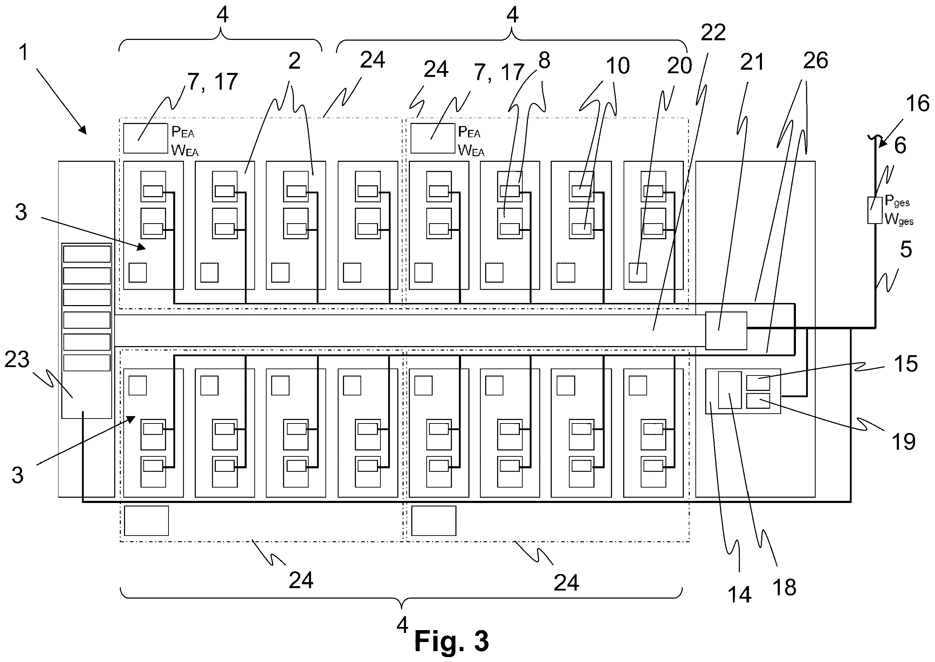

Fig. 3 zeigt eine andere Ausführung einer Spinn- oder Spulmaschine 1, bei welcher die Arbeitsorgane 8 mittels Einzelantrieben 10 angetrieben sind. Die Arbeitsstellen 2 sind, wie bei Spinn-oder Spulmaschinen 1 üblich, baulich in Sektionen 24 gegliedert. Die Arbeitsstellen 2 sind vorliegend als autarke Arbeitsstellen 2 ausgebildet, die völlig unabhängig von anderen Arbeitsstellen 2, auch unabhängig von denen derselben Sektion 24, betrieben werden können. Jede Sektion 24 weist eine Sektionssteuereinheit 17 auf, welche mittels Steuerdaten die verschiedenen Einzelantriebe 10 ansteuert oder derartige Steuerdaten an den verschiedenen Einzelantriebe 10 weiterleitet.

Da die einzelnen Arbeitsstellen 2 unabhängig von anderen Arbeitsstellen 2 betrieben werden können, können diese auch beliebig und unabhängig von der baulichen Gliederung in Sektionen 24 in verschiedene Produktionsgruppen 4 unterteilt werden. Dabei ist es auch nicht erforderlich, dass die einzelnen, einer Produktionsgruppe 4 zugehörigen Arbeitsstellen 2 zueinander benachbart sind.

Die Messung der Gesamtleistung Pges erfolgt wie zuvor beschrieben mittels der ersten Messeinrichtung 6. Die Messung der Leistung PAO der Arbeitsorgane 8 der Arbeitsstellen 2 einer Produktionsgruppe 4 ist jedoch aufgrund der willkürlichen Zuordnung der Arbeitsstellen 2 zu den verschiedenen Produktionsgruppen nicht möglich. Die Leistung PAO der Arbeitsorgane 8 einer Produktionsgruppe 4 wird daher ermittelt, indem die einzelnen Leistungen PEA der Einzelantriebe 10 ermittelt oder gemessen werden und zueinander addiert werden. Beispielsweise können die Leistungen PEA der Einzelantriebe 10 durch in die Einzelantriebe 10 integrierte Erfassungseinrichtungen gemessen werden. Ebenso ist es möglich, die Leistungen PEA der Einzelantriebe 10 anhand von Steuerdaten der Einzelantriebe 10, beispielsweise mittels der Sektionssteuereinheiten 17, zu ermitteln. Die Sektionssteuereinheiten 17 bilden in diesem Fall jeweils eine weitere Messeinrichtung 7, welche mehreren Einzelantrieben 10 und dadurch zumindest temporär auch jeweils einer oder mehreren Produktionsgruppen 4 zugeordnet ist.

Zur Berechnung der Produktionsgruppenleistungen PPG werden dann wiederum die Leistungen PAO der Arbeitsorgane 8 der Produktionsgruppen 4 in ein Verhältnis zueinander gesetzt und die gemessene Gesamtleistung Pges entsprechend diesem Verhältnis auf die Produktionsgruppen 4 aufgeteilt. Dies wird ebenfalls an einem Zahlenbeispiel erläutert: Beispielsweise wird über die erste Messeinrichtung 6 eine Gesamtleistung Pges der Spinn- oder Spulmaschine von 100 kW gemessen. Weiterhin werden die einzelnen Leistungen der Einzelantriebe PEA einer Produktionsgruppe 4, die vorliegend durch die Sektionssteuerungen 17 bereit gestellt werden, für die erste Produktionsgruppe 4 zu einer Leistung PAO von 30 kW, für die zweite Produktionsgruppe zu einer Leistung PAO von 40 KW und für die dritte Produktionsgruppe zu einer Leistung PAO von 20 KW aufaddiert. Die Leistung aller Arbeitsorgane 8 aller Produktionsgruppen 4 beträgt demnach lediglich 90 kW.

Nun wird das Verhältnis der elektrischen Leistungen PAO der Arbeitsorgane 8 der Produktionsgruppen 4 gebildet, das vorliegend 3:4:2 beträgt. Die gemessene Gesamtleitung Pges wird nun im Verhältnis 3:4:2 auf die drei Produktionsgruppen 4 aufgeteilt, d.h. 3/9 der gemessenen Gesamtleistung Pges von 100 kW werden der ersten Produktionsgruppe 4 zugeschlagen, 4/9 der Gesamtleistung Pges der zweiten Produktionsgruppe 4 und 2/9 der dritten Produktionsgruppe. Die so berechnete Produktionsgruppenleistung PPG für die erste Produktionsgruppe 4 beträgt somit 33,3 kW, für die zweite Produktionsgruppe 4 44,4 kW und für die dritte Produktionsgruppe 4 22,2 kW.

In analoger Weise kann zusätzlich oder alternativ auch ein Produktionsgruppenenergieverbrauch WPG berechnet werden.

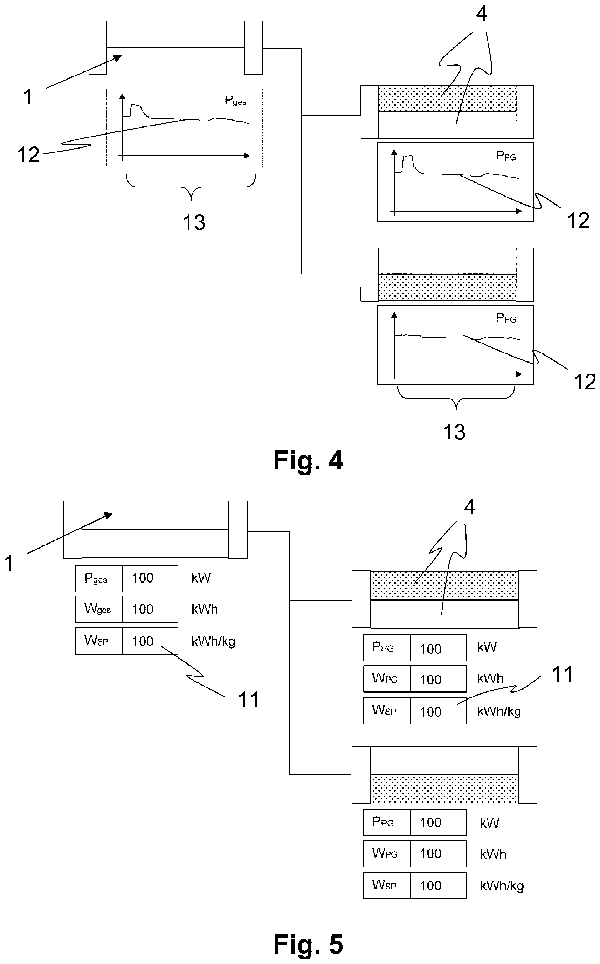

Wie im Folgenden anhand der Fig. 4 und 5 dargestellt, kann das Anzeigen der elektrischen Leistungs -und/oder Energieverbrauchsdaten mittels der Anzeigeeinheit 18 in vielfältiger Weise erfolgen.

Fig. 4 zeigt eine erste Ausführung, bei welcher sowohl die elektrische Gesamtleistung Pges der Spinn- oder Spulmaschine 1 als auch die Produktionsgruppenleistungen PPG als zeitabhängiger Graph 12 dargestellt werden. Es wird somit der Verlauf der Leistungen Pges und PPG über die Zeit innerhalb eines bestimmten Zeitfensters 13 dargestellt.

Die vorliegend gezeigte Spinn- oder Spulmaschine 1 weist lediglich zwei Produktionsgruppen 4 auf, deren Produktionsgruppenleistungen PPG vorliegend zusammen mit der Gesamtleistung Pges auf einem Bildschirm dargestellt sind. Um die einzelnen Produktionsgruppenleistungen PPG den jeweiligen Produktionsgruppen 4 zuordnen zu können, ist die jeweils dargestellte Produktionsgruppe 4 in der Darstellung entsprechend markiert, vorliegend gepunktet dargestellt. Natürlich könnten in ähnlicher Weise auch mehrere Produktionsgruppen 4 gemeinsam dargestellt werden. Ebenfalls ist es denkbar, dass eine Anzeige lediglich auf Abruf und beispielsweise auch für bestimmte Produktionsgruppen 4 wählbar erfolgt.

Demgegenüber werden bei der Anzeige der Figur 5 die elektrische Gesamtleistung Pges der Spinn- oder Spulmaschine 1 und die Produktionsgruppenleistungen PPG als aktuelle Werte 11 numerisch angezeigt. Die jeweils dargestellte Produktionsgruppe 4 ist dabei wiederum entsprechend gekennzeichnet. Vorliegend werden nicht nur die elektrische Gesamtleistung Pges und die Produktionsgruppenleistungen PPG dargestellt, sondern es werden zusätzlich auch der elektrische Gesamtenergieverbrauch Wges und die Produktionsgruppenenergieverbräuche WPG angezeigt. Zusätzlich wurde im vorliegenden Beispiel auch ein spezifischer Energieverbrauch WSP sowohl für jede der Produktionsgruppen 4 als auch für die gesamte Spinn- oder Spulmaschine 1 berechnet und angezeigt.

Durch die Anzeige der Produktionsgruppenleistungen PPG und der spezifischen Energieverbräuche WSP für jede Produktionsgruppe 4 kann das Bedienpersonal sehr schnell Rückschlüsse auf Fehler im Prozess oder auch auf die Qualität des produzierten Garnes ziehen und bei Bedarf entsprechende Gegenmaßnahmen, beispielsweise Wartungsarbeiten oder Einstellungsoptimierungen, einleiten.

Vorzugsweise kann dabei das Bedienpersonal wählen, ob die Anzeige als Graph 12 oder als aktueller, numerischer Wert 11 erfolgen soll. Die Anzeigeeinheit 18 muss auch nicht an einem Maschinenende der Spinn- oder Spulmaschine 1 angeordnet sein, sondern kann sich an einer anderen Stelle der Spinn- oder Spulmaschine 1 befinden, beispielsweise in der Nähe einer Produktionsgruppe 4, oder abseits der Spinn- oder Spulmaschine 1 in einem Kontrollraum.

Dabei können sowohl nur die Leistungen als auch nur die Energieverbräuche berechnet und/oder angezeigt werden. Ebenso kann jedoch auch eine kombinierte Anzeige wie beispielsweise in Fig. 5 gezeigt erfolgen. Ebenso ist es auch denkbar, temporär oder nach Wahl des Bedieners von der Berechnung der Leistungen auf die Berechnung der Energieverbräuche umzustellen und umgekehrt, was ebenso auch für das Anzeigen der ermittelten Energieverbräuche oder Leistungen gilt.

Die vorliegende Erfindung ist nicht auf die dargestellten und beschriebenen Ausführungsbeispiele beschränkt. So ist es beispielsweise keineswegs erforderlich, bei der Ermittlung der Leistungen PAO der Arbeitsorgane 8 einer Produktionsgruppe 4 alle zentralen Antriebe 9 bzw. alle Einzelantriebe 10 verschiedener Arbeitsorgane 8 zu berücksichtigen. Da die Ermittlung der Leistungen PAO lediglich dazu dient, einen Verteilungsschlüssel für die Gesamtleistung Pges auf die einzelnen Produktionsgruppen 4 zu ermitteln, ist es auch möglich, lediglich die Leistungen PAO bestimmter Arbeitsorgane 8 zu ermitteln, welche charakteristisch für die Leistung und/oder den Energieverbrauch an den Arbeitsstellen sind. Beispielsweise könnten im Falle einer Rotorspinnmaschine lediglich die Rotorantriebe zur Ermittlung der Leistung PAO der Arbeitsorgane 8 einer Produktionsgruppe 4 herangezogen werden. Dies gilt sowohl für zentral angetriebene Arbeitsorgane 8 als auch für einzeln angetriebene Arbeitsorgane 8. Weitere Abwandlungen im Rahmen der Patentansprüche sind ebenfalls möglich.

### Bezugszeichenliste

- 1: Spinn- oder Spulmaschine
- 2: Arbeitsstelle
- 3: Längsseite der Spinn- oder Spulmaschine
- 4: Produktionsgruppe
- 5: Stromkabel
- 6: erste Messeinrichtung
- 7: weitere Messeinrichtung
- 8: elektrisches Arbeitsorgan
- 9: zentraler Antrieb
- 10: Einzelantrieb
- 11: aktueller Wert
- 12: Graph
- 13: Zeitfenster
- 14: Steuereinheit
- 15: Auswerteeinheit
- 16: Netzanschluss
- 17: Sektionssteuereinheit
- 18: Anzeigeeinheit
- 19: Speichermedium
- 20: Verbraucher
- 21: Ventilatorantrieb
- 22: Unterdruckkanal
- 23: Hülsenlader
- 24: Sektion
- 25: Antriebsmittel
- 26: Leitungsstrang

- Pges: elektrische Gesamtleistung
- Wges: elektrischer Gesamtenergieverbrauch
- PAO: elektrische Leistung der Arbeitsorgane einer Produktionsgruppe
- WAO: elektrischer Energieverbrauch der Arbeitsorgane einer Produktionsgruppe
- PEA: elektrische Leistung eines Einzelantriebs
- WEA: Energieverbrauch eines Einzelantriebs
- PPG: Produktionsgruppenleistung
- WPG: Produktionsgruppenenergieverbrauch
- WSP: spezifischer Energieverbrauch

## Patentansprüche

1. Verfahren zum Bestimmen einer elektrischen Leistung und/oder eines elektrisches Energieverbrauchs an einer Spinn- oder Spulmaschine (1), insbesondere einer Offenend- oder Luftspinnmaschine, mit einer Vielzahl nebeneinander angeordneter Arbeitsstellen (2), welche jeweils wenigstens ein elektrisches Arbeitsorgan (8) aufweisen, wobei bei dem Verfahren eine elektrische Gesamtleistung (Pges) und/oder ein elektrischer Gesamtenergieverbrauch (Wges) der Spinn- oder Spulmaschine (1) ermittelt wird, **dadurch gekennzeichnet,**
**dass** die Arbeitsstellen (2) in wenigstens zwei unabhängig voneinander betreibbare Produktionsgruppen (4) unterteilt werden,
**dass** die elektrische Gesamtleistung (Pges) und/oder der elektrische Gesamtenergieverbrauch (Wges) der Spinn- oder Spulmaschine (1) mittels einer ersten, zentralen Messeinrichtung (6) gemessen wird, dass weiterhin ein Verteilerschlüssel vorgegeben wird,
**dass** für jede der Produktionsgruppen (4) eine Produktionsgruppenleistung (PPG) und/oder ein Produktionsgruppenenergieverbrauch (WPG) berechnet wird, indem die elektrische Gesamtleistung (Pges) und/oder der elektrische Gesamtenergieverbrauch (Wges) der Spinn-oder Spulmaschine (1) mittels des Verteilerschlüssels auf die einzelnen Produktionsgruppen (4) aufgeteilt wird
und **dass** die Produktionsgruppenleistung (PPG) und/oder der Produktionsgruppenenergieverbrauch (WPG) an der Spinn- oder Spulmaschine angezeigt wird und/oder an einen der Spinn- oder Spulmaschine (1) übergeordneten Rechner übermittelt wird.

2. Verfahren nach dem vorherigen Anspruch, **dadurch gekennzeichnet, dass** ein spezifischer Energieverbrauch (WSP) in kWh/g Garn oder in kWh/m Garn für jede der Produktionsgruppen (4) und/oder für die gesamte Spinn- oder Spulmaschine (1) bestimmt wird und vorzugsweise an der Spinn- oder Spulmaschine angezeigt wird und/oder an einen der Spinn- oder Spulmaschine (1) übergeordneten Rechner übermittelt wird.

3. Verfahren nach einem der vorherigen Ansprüche, **dadurch gekennzeichnet, dass** die gemessene elektrische Gesamtleistung (Pges) und/oder der gemessene elektrische Gesamtenergieverbrauch (Wges) entsprechend der Anzahl aktiv arbeitender Arbeitsstellen auf die einzelnen Produktionsgruppen (4) aufgeteilt wird.

4. Verfahren nach einem der vorherigen Ansprüche, **dadurch gekennzeichnet, dass** die gemessene elektrische Gesamtleistung (Pges) und/oder der gemessene elektrische Gesamtenergieverbrauch (Wges) entsprechend der Anzahl der Ansetzvorgänge innerhalb eines bestimmten Zeitraums auf die einzelnen Produktionsgruppen (4) aufgeteilt wird.

5. Verfahren nach einem der vorherigen Ansprüche, **dadurch gekennzeichnet, dass** für jede der Produktionsgruppen (4) eine elektrische Leistung (PAO) und/oder ein elektrischer Energieverbrauch (WAO) der Arbeitsorgane (8) der Arbeitsstellen (2) der jeweiligen Produktionsgruppe (4) ermittelt wird und die so ermittelten elektrischen Leistungen (PAO) und/oder Energieverbräuche (WAO) in ein Verhältnis zueinander gesetzt werden und die gemessene elektrische Gesamtleistung (Pges) und/oder der gemessene elektrische Gesamtenergieverbrauch (Wges) der Spinn- oder Spulmaschine (1) entsprechend dem Verhältnis der ermittelten Leistungen (PAO) und/oder Energieverbräuche (WAO) der Arbeitsorgane (8) der Produktionsgruppen (4) auf die einzelnen Produktionsgruppen (4) aufgeteilt wird.

6. Verfahren nach Anspruch 5, **dadurch gekennzeichnet, dass** die Leistung (PAO) und/oder der Energieverbrauch (WAO) der Arbeitsorgane (8) einer Produktionsgruppe (4) durch eine weitere, der jeweiligen Produktionsgruppe (4) zugeordnete Messeinrichtung (7), insbesondere einen Aufsteckwandler, gemessen werden.

7. Verfahren nach einem der vorherigen Ansprüche, **dadurch gekennzeichnet, dass** das wenigstens eine elektrische Arbeitsorgan (8) jeder Arbeitsstelle (2) durch einen arbeitsstelleneigenen Einzelantrieb (10) angetrieben wird.

8. Verfahren nach Anspruch 7, **dadurch gekennzeichnet, dass** eine Leistung (PEA) und/oder ein Energieverbrauch (WEA) des wenigstens einen arbeitsstelleneigenen Einzelantriebs (10) mittels einer weiteren, dem Einzelantrieb (10) zugeordneten Messeinrichtung (7) gemessen wird und die Leistung (PAO) und/oder der Energieverbrauch (WAO) der Arbeitsorgane (8) einer Produktionsgruppe (4) ermittelt wird, indem die einzelnen Leistungen (PEA) und/oder Energieverbräuche (WEA) der Einzelantriebe (10) der zu der jeweiligen Produktionsgruppe (4) gehörenden Arbeitsstellen (2) addiert werden.

9. Verfahren nach einem der vorherigen Ansprüche, **dadurch gekennzeichnet, dass** die Gesamtleistung (Pges) und/oder die Produktionsgruppenleistungen (PPG) und/oder der Gesamtenergieverbrauch (Wges) und/oder die Produktionsgruppenenergieverbräuche (WPG) und/oder der spezifische Energieverbrauch (WSP) zumindest in bestimmten Zeitabständen, vorzugsweise laufend, berechnet werden und abgespeichert und/oder angezeigt und/oder an einen der Spinn-oder Spulmaschine (1) übergeordneten Rechner übermittelt werden.

10. Verfahren nach einem der vorherigen Ansprüche, **dadurch gekennzeichnet, dass** die Gesamtleistung (Pges) und/oder die Produktionsgruppenleistungen (PPG) und/oder der Gesamtenergieverbrauch (Wges) und/oder die Produktionsgruppenenergieverbräuche (WPG) und/oder der spezifische Energieverbrauch (WSP) als aktueller Wert (11), insbesondere numerisch, und/oder als zeitabhängiger Graph (12) angezeigt werden, wobei vorzugsweise ein Zeitfenster (13) des zeitabhängigen Graphen (12) rollend ist oder zu einem vorgebbaren und/oder vorgegebenen Zeitpunkt beginnt.

11. Spinn- oder Spulmaschine (1), insbesondere Offenend- oder Luftspinnmaschine, mit einer Vielzahl nebeneinander angeordneter Arbeitsstellen (2), welche jeweils wenigstens ein elektrisches Arbeitsorgan (8) aufweisen, **gekennzeichnet durch** eine erste, zentrale Messeinrichtung (6) zur Messung einer Gesamtleistung (Pges) oder eines Gesamtenergieverbrauchs (Wges) der Spinn- oder Spulmaschine (1), sowie eine Steuereinheit (14) zur Durchführung des Verfahrens nach einem der vorherigen Ansprüche.

12. Spinn- oder Spulmaschine (1) nach dem vorherigen Anspruch, **dadurch gekennzeichnet, dass** die erste, zentrale Messeinrichtung (6) als Leistungsmessmodul ausgebildet ist und vorzugsweise im Bereich eines Netzanschlusses (16) der Spinn- oder Spulmaschine (1) angeordnet ist.

13. Spinn- oder Spulmaschine (1) nach einem der vorherigen Vorrichtungsansprüche, **dadurch gekennzeichnet, dass** die Spinn- oder Spulmaschine (1) wenigstens eine weitere Messeinrichtung (7) zur Messung einer Leistung (PEA) und/oder eines Energieverbrauchs (WEA) eines arbeitsstelleneigenen Einzelantriebs (10) und/oder der Arbeitsorgane (8) einer Produktionsgruppe (4) aufweist.

14. Spinn- oder Spulmaschine (1) nach einem der vorherigen Vorrichtungsansprüche, **dadurch gekennzeichnet, dass** die Arbeitsstellen (2) als zumindest teilweise autarke Arbeitsstellen (2) ausgebildet sind, wobei das wenigstens eine Arbeitsorgan (8) mittels eines Einzelantriebs (10) angetrieben ist.

15. Spinn- oder Spulmaschine (1) nach Anspruch 13, **dadurch gekennzeichnet, dass** die wenigstens eine weitere Messeinrichtung (7) eine dem Einzelantrieb (10) zugeordnete Steuereinheit (14) ist oder dass die wenigstens eine weitere Messeinrichtung (7) als eine in den Einzelantrieb (10) integrierte Erfassungseinrichtung ausgebildet ist.

## Claims

1. A method for determining an electrical power and/or an electrical energy consumption at a spinning machine or winder (1), in particular an open-end or air-jet spinning machine, comprising a plurality of adjacently arranged workstations (2), which each comprise at least one electrical working element (8), wherein, in the method, a total electrical power (Pges) and/or a total electrical energy consumption (Wges) of the spinning machine or winder (1) is determined, **characterized in that**
the workstations (2) are subdivided into at least two production groups (4), which can be operated independently of one another,
the total electrical power (Pges) and/or the total electrical energy consumption (Wges) of the spinning machine or winder (1) are/is measured with the aid of a first, central measuring unit (6), moreover, a ratio of distribution is predefined,
a production group power (PPG) and/or a production group energy consumption (WPG) are/is calculated for each of the production groups (4), **in that** the total electrical power (Pges) and/or the total electrical energy consumption (Wges) of the spinning machine or winder (1) are/is allocated to the individual production groups (4) with the aid of the ratio of distribution,
and the production group power (PPG) and/or the production group energy consumption (WPG) are/is displayed at the spinning machine or winder and/or transmitted to a computer that is at a higher level than the spinning machine or winder (1).

2. The method as claimed in the preceding claim, **characterized in that** a specific energy consumption (WSP) in kWh/g yarn or in kWh/m yarn is determined for each of the production groups (4) and/or for the entire spinning machine or winder (1) and is preferably displayed at the spinning machine or winder and/or is transmitted to a computer that is at a higher lever than the spinning machine or winder (1).

3. The method as claimed in one of the preceding claims, **characterized in that** the measured total electrical power (Pges) and/or the measured total electrical energy consumption (Wges) are/is allocated to the individual production groups (4) according to the number of actively operating workstations.

4. The method as claimed in one of the preceding claims, **characterized in that** the measured total electrical power (Pges) and/or the measured total electrical energy consumption (Wges) are/is allocated to the individual production groups (4) according to the number of piecing operations within a certain period.

5. The method as claimed in one of the preceding claims, **characterized in that**, for each of the production groups (4), an electrical power (PAO) and/or an electrical energy consumption (WAO) of the working elements (8) of the workstations (2) of the particular production group (4) are/is determined and the electrical powers (PAO) and/or energy consumptions (WAO) determined in this way are expressed as a ratio with respect to one another, and the measured total electrical power (Pges) and/or the measured total electrical energy consumption (Wges) of the spinning machine or winder (1) are/is allocated to the individual production groups (4) according to the ratio of the determined powers (PAO) and/or energy consumptions (WAO) of the working elements (8) of the production groups (4).

6. The method as claimed in claim 5, **characterized in that** the power (PAO) and/or the energy consumption (WAO) of the working elements (8) of a production group (4) are/is measured by a further measuring unit (7), in particular a slip-over transformer, associated with the particular production group (4).

7. The method as claimed in one of the preceding claims, **characterized in that** the at least one electrical working element (8) of each workstation (2) is driven by a workstation-specific single drive (10).

8. The method as claimed in claim 7, **characterized in that** a power (PEA) and/or an energy consumption (WEA) of the at least one workstation-specific single drive (10) are/is measured with the aid of a further measuring unit (7) associated with the single drive (10), and the power (PAO) and/or the energy consumption (WAO) of the working elements (8) of a production group (4) are/is determined, **in that** the individual powers (PEA) and/or energy consumptions (WEA) of the single drives (10) of the workstations (2) belonging to the particular production group (4) are added.

9. The method as claimed in one of the preceding claims, **characterized in that** the total power (Pges) and/or the production group powers (PPG) and/or the total energy consumption (Wges) and/or the production group energy consumptions (WPG) and/or the specific energy consumption (WSP) are/is calculated and stored and/or displayed and/or transmitted to a computer, which is at a higher level than the spinning machine or winder (1), at least at certain time intervals, preferably continuously.

10. The method as claimed in one of the preceding claims, **characterized in that** the total power (Pges) and/or the production group powers (PPG) and/or the total energy consumption (Wges) and/or the production group energy consumptions (WPG) and/or the specific energy consumption (WSP) are/is displayed as an instantaneous value (11), in particular numerically, and/or as a time-dependent graph (12), wherein preferably a time window (13) of the time-dependent graph (12) is rolling or begins at a predefinable and/or predefined point in time.

11. A spinning machine or winder (1), in particular an open-end or air-jet spinning machine, comprising a plurality of adjacently arranged workstations (2), which each comprise at least one electrical working element (8), **characterized by** a first, central measuring unit (6) for measuring a total power (Pges) or a total energy consumption (Wges) of the spinning machine or winder (1), and a control unit (14) for carrying out the method as claimed in one of the preceding claims.

12. The spinning machine or winder (1) as claimed in the preceding claim, **characterized in that** the first, central measuring unit (6) is designed as a power measuring module and is preferably arranged in the area of a mains connection (16) of the spinning machine or winder (1).

13. The spinning machine or winder (1) as claimed in one of the preceding device claims, **characterized in that** the spinning machine or winder (1) comprises at least one further measuring unit (7) for measuring a power (PEA) and/or an energy consumption (WEA) of a workstation-specific single drive (10) and/or the working elements (8) of a production group (4).

14. The spinning machine or winder (1) as claimed in one of the preceding device claims, **characterized in that** the workstations (2) are designed as at least partially autonomous workstations (2), wherein the at least one working element (8) is driven with the aid of a single drive (10).

15. The spinning machine or winder (1) as claimed in claim 13, **characterized in that** the at least one further measuring unit (7) is a control unit (14) associated with the single drive (10), or the at least one further measuring unit (7) is designed as an acquisition unit integrated into the single drive (10).

## Revendications

1. Procédé pour déterminer une puissance électrique et/ou une consommation d'énergie électrique sur une machine de filature ou de bobinage (1), en particulier une machine de filature à bout libre ou à jet d'air, avec une pluralité de postes de travail (2) disposés les uns à côté des autres, qui présentent chacun au moins un organe de travail électrique (8), une puissance électrique totale (Pges) et/ou une consommation d'énergie électrique totale (Wges) de la machine de filature ou de bobinage (1) étant déterminée(s) lors du procédé, **caractérisé en ce que** les postes de travail (2) sont divisés en au moins deux groupes de production (4) pouvant être exploités indépendamment l'un de l'autre,
la puissance électrique totale (Pges) et/ou la consommation d'énergie électrique totale (Wges) de la machine de filature ou de bobinage (1) est/sont mesurée(s) au moyen d'un premier dispositif de mesure central (6),
une clé de répartition continue d'être allouée,
pour chacun des groupes de production (4), il est calculé une puissance de groupe de production (PPG) et/ou une consommation d'énergie de groupe de production (WPG) en répartissant la puissance électrique totale (Pges) et/ou la consommation d'énergie électrique totale (Wges) de la machine de filature ou de bobinage (1) sur les différents groupes de production (4) au moyen de la clé de répartition
et **en ce que** la puissance de groupe de production (PPG) et/ou la consommation d'énergie de groupe de production (WPG) est/sont affichée(s) (2) sur la machine de filature ou de bobinage et/ou est/sont transmise(s) à un calculateur supérieur à la machine de filature ou de bobinage (1).

2. Procédé selon la revendication précédente, caractérisé en ce qu'une consommation d'énergie spécifique (WSP) en kWh/g de fil ou en kWh/m de fil est déterminée pour chacun des groupes de production (4) et/ou pour l'ensemble de la machine de filature ou de bobinage (1) et est de préférence affichée sur la machine de filature ou de bobinage et/ou transmise à un calculateur supérieur à la machine de filature ou de bobinage (1).

3. Procédé selon l'une quelconque des revendications précédentes, **caractérisé en ce que** la puissance électrique totale mesurée (Pges) et/ou la consommation d'énergie électrique totale mesurée (Wges) est/sont répartie(s) entre les différents groupes de production (4) en fonction du nombre de postes de travail travaillant activement.

4. Procédé selon l'une quelconque des revendications précédentes, **caractérisé en ce que** la puissance électrique totale mesurée (Pges) et/ou la consommation d'énergie électrique totale mesurée (Wges) est/sont répartie(s) entre les différents groupes de production (4) en fonction du nombre d'opérations de rattachement pendant un intervalle de temps déterminé.

5. Procédé selon l'une quelconque des revendications précédentes, **caractérisé en ce que**, pour chacun des groupes de production (4), il est déterminé une puissance électrique (PAO) et/ou une consommation d'énergie électrique (WAO) des organes de travail (8) des postes de travail (2) du groupe de production (4) respectif et les puissances électriques (PAO) et/ou les consommations d'énergie (WAO) ainsi déterminées sont mises en relation les unes avec les autres et la puissance électrique totale (Pges) mesurée et/ou la consommation d'énergie électrique totale (Wges) mesurée de la machine de filature ou de bobinage (1) est/sont répartie entre les différents groupes de production (4) en fonction du rapport entre les puissances (PAO) et/ou les consommations d'énergie (WAO) déterminées des organes de travail (8) des groupes de production (4).

6. Procédé selon la revendication 5, **caractérisé en ce que** la puissance (PAO) et/ou la consommation d'énergie (WAO) des organes de travail (8) d'un groupe de production (4) est/sont mesurée(s) par un dispositif de mesure (7) supplémentaire associé au groupe de production (4) respectif, en particulier un transducteur enfichable.

7. Procédé selon l'une quelconque des revendications précédentes, **caractérisé en ce que** l'au moins un organe de travail électrique (8) de chaque poste de travail (2) est entraîné par un entraînement individuel (10) propre au poste de travail.

8. Procédé selon la revendication 7, caractérisé en ce qu'une puissance (PEA) et/ou une consommation d'énergie (WEA) de l'au moins un entraînement individuel (10) propre au poste de travail est/sont mesurée(s) au moyen d'un dispositif de mesure (7) supplémentaire associé à l'entraînement individuel (10) et la puissance (PAO) et/ou la consommation d'énergie (WAO) des organes de travail (8) d'un groupe de production (4) est/sont déterminée(s) par addition des puissances individuelles (PEA) et/ou des consommations d'énergie (WEA) des entraînements individuels (10) des postes de travail (2) appartenant au groupe de production (4) respectif.

9. Procédé selon l'une quelconque des revendications précédentes, **caractérisé en ce que** la puissance totale (Pges) et/ou les puissances des groupes de production (PPG) et/ou la consommation d'énergie totale (Wges) et/ou les consommations d'énergie des groupes de production (WPG) et/ou la consommation d'énergie spécifique (WSP) sont calculées au moins à des intervalles de temps déterminés, de préférence en continu, et sont mémorisées et/ou affichées et/ou transmises à un calculateur supérieur à la machine de filature ou de bobinage (1).

10. Procédé selon l'une quelconque des revendications précédentes, **caractérisé en ce que** la puissance totale (Pges) et/ou les puissances des groupes de production (PPG et/ou la consommation d'énergie totale (Wges) et/ou les consommations d'énergie des groupes de production (WPG) et/ou la consommation d'énergie spécifique (WSP) sont affichées en tant que valeur actuelle (11), en particulier numérique, et/ou en tant que graphe (12) dépendant du temps, dans lequel une fenêtre temporelle (13) du graphe (12) dépendant du temps est de préférence défilante ou commence à un instant prédéterminable et/ou prédéterminé.

11. Machine de filature ou de bobinage (1), en particulier une machine de filature à bout libre ou à jet d'air, avec une pluralité de postes de travail (2) disposés les uns à côté des autres, qui présentent chacun au moins un organe de travail électrique (8), **caractérisée par** un premier dispositif de mesure central (6) pour mesurer une puissance totale (Pges) ou une consommation d'énergie totale (Wges) de la machine de filature ou de bobinage (1), ainsi que par une unité de commande (14) pour la mise en oeuvre du procédé selon l'une quelconque des revendications précédentes.

12. Machine de filature ou de bobinage (1) selon la revendication précédente, **caractérisée en ce que** le premier dispositif de mesure central (6) est conçu en tant que module de mesure de puissance et est disposé de préférence dans la zone d'un raccordement au secteur (16) de la machine de filature ou de bobinage (1).

13. Machine de filature ou de bobinage (1) selon l'une quelconque des revendications de dispositif précédentes, **caractérisée en ce que** la machine de filature ou de bobinage (1) présente au moins un dispositif de mesure (7) supplémentaire pour mesurer une puissance (PEA) et/ou une consommation d'énergie (WEA) d'un entraînement individuel (10) propre au poste de travail et/ou des organes de travail (8) d'un groupe de production (4).

14. Machine de filature ou de bobinage (1) selon l'une quelconque des revendications de dispositif précédentes, **caractérisée en ce que** les postes de travail (2) sont réalisés en tant que postes de travail (2) au moins partiellement autonomes, le, au moins un, organe de travail (8) étant entraîné au moyen d'un entraînement individuel (10).

15. Machine de filature ou de bobinage (1) selon la revendication 13, **caractérisée en ce que** le, au moins un, dispositif de mesure (7) supplémentaire est une unité de commande (14) associée à l'entraînement individuel (10) ou **en ce que** le, au moins un, dispositif de mesure (7) supplémentaire est réalisé en tant que dispositif de détection intégré dans l'entraînement individuel (10).
